# EUROPÄISCHE PATENTANMELDUNG

(11) **EP 4 685 918 A1**
(43) Veröffentlichungstag der Anmeldung: **28.01.2026**
(21) Anmeldenummer: 24190344.2
(22) Anmeldetag: 23.07.2024
(51) Int. Cl.: H01M 10/42, G01R 31/385, G01R 31/389, H01M 10/44, H01M 10/48

(54) **VERFAHREN ZUM ÜBERWACHEN EINES FORMIERUNGSPROZESSES EINER BATTERIEZELLE MITTELS EINER FORMIERUNGSVORRICHTUNG, COMPUTERPROGRAMMPRODUKT, COMPUTERLESBARES SPEICHERMEDIUM SOWIE FORMIERUNGSVORRICHTUNG**

(71) Anmelder: Siemens Aktiengesellschaft, 80333 München (DE)
(72) Erfinder: Fischer, Michael, 91320 Ebermannstadt (DE); Katzer, Felix, 90763 Fürth (DE); Radinger, Hannes, 86152 Augsburg (DE)
(74) Vertreter: Siemens Patent Attorneys

(57) **Zusammenfassung**

Die Erfindung betrifft ein Verfahren zum Überwachen eines Formierungsprozesses einer Batteriezelle (14) mittels einer Formierungsvorrichtung (10), mit den Schritten: Laden der Batteriezelle (14) mit zumindest einem ersten Formierungsstrom (26) mittels einer Ladeeinrichtung (16) der Formierungsvorrichtung (10); Durchführen zumindest einer Impedanzmessung (32) während des Formierungsprozesses mittels einer Erfassungseinrichtung (18) der Formierungsvorrichtung (10); Vorgeben eines Ersatzschaltbildes der Batteriezelle (14) im Formierungsprozess mittels einer elektronischen Recheneinrichtung (20) der Formierungsvorrichtung (10); Bestimmen von zumindest einem Parameter (30) des Ersatzschaltbildes in Abhängigkeit von der durchgeführten Impedanzmessung (32) mittels der elektronischen Recheneinrichtung (20); und Überwachen des Formierungsprozesses in Abhängigkeit von dem bestimmten zumindest einem Parameter (30) mittels der elektronischen Recheneinrichtung (20). Ferner betrifft die Erfindung ein Computerprogrammprodukt, ein computerlesbares Speichermedium sowie eine elektronische Recheneinrichtung (20).

## Beschreibung

Die nachfolgende Erfindung betrifft ein Verfahren zum Überwachen eines Formierungsprozesses einer Batteriezelle mittels einer Formierungsvorrichtung gemäß dem geltenden Patentanspruch 1. Ferner betrifft die Erfindung ein entsprechendes Computerprogrammprodukt, ein entsprechendes computerlesbares Speichermedium sowie eine entsprechende Formierungsvorrichtung.

Die Formierung einer Batteriezelle ist einer der letzten Produktionsschritte in der Zellproduktion und findet statt, nachdem die Batteriezelle mit dem Elektrolyten befüllt und verschlossen wurde, und bevor diese in die Lagerung und End-of-Line-Qualitätskontrolle geht. Der Formierungsprozess umfasst die ersten Lade- beziehungsweise Entladevorgänge der vollständig assemblierten Batteriezelle und soll einen definierten und für die spätere Verwendung optimalen Ausgangszustand gewährleisten. Bei Lithium-lonen-Batteriezellen und verwandten Technologien ist die Bildung einer wohl definierten Solid Electrolyte Interface (SEI) an der Oberfläche der Anode das zentrale Ziel. Diese bildet sich durch Reaktionen des Elektrolyten am Aktivmaterial in bestimmten Spannungs- und gegebenenfalls Temperaturbereichen, die während der Ladevorgänge beziehungsweise Entladevorgänge in der Formierung durchlaufen werden.

In einer Batteriezelle treten mehrere komplexe Reaktionen simultan auf, die sich zudem in ihrer Reaktionskinetik voneinander unterscheiden. Es gilt zu beachten, dass jede elektrochemische Reaktion, einschließlich der Reaktionen, die zur SEI-Formierung beitragen, abhängig vom Potential am Ort der Reaktion stattfindet.

Falls der zeitliche Verlauf der vorgegebenen Stromstärke oder auch der angelegten Spannung nicht für jede individuelle Batteriezelle richtig gewählt wird, kann es dazu kommen, dass sich Potentiale an den Grenzflächen einstellen, die nicht für die Bildung der optimalen SEI geeignet sind, oder dass bereits weitere Reaktionen, zum Beispiel Aufladen der Elektrodenmaterialien, beschleunigt stattfinden, die ihrerseits die SEI-Formierung negativ beeinflussen. Der Prozess muss also zwingend geeignete Strom-/Spannungs- sowie Temperaturverläufe zur Bildung der gewünschten SEI ermöglichen. Auf der anderen Seite ist die Formierung auch eine der zeit- und energieintensivsten Prozesse in der Zellproduktion, so dass die Prozessverläufe auch möglichst effizient gehalten werden müssen, um die Kosten der Zellproduktion zu minimieren. Diese beiden Anforderungen sowie die komplexen zugrundeliegenden chemischen Reaktionen stellen hohe Ansprüche an die Definition und Kontrolle der Prozessparameter während der Formierung.

Aus dem Stand der Technik ist bereits bekannt, dass die Formierungsprozesse Stromstärken und gegebenenfalls Spannungs- und Temperaturverläufe basierend auf empirischen Tests an den produzierten Batteriezellen wählen. Dabei werden die Prozessparameter so gewählt, dass sie einen möglichst guten Kompromiss aus Zellqualität und Prozesskosten darstellen. Zur Kontrolle des Formierungsprozesses werden lediglich Strom, Spannung und eventuell die Temperatur der Batteriezelle aufgenommen. Dieses Vorgehen benötigt einerseits eine möglichst genaue Kenntnis der verfügbaren Prozessfenster und kann andererseits Streuungen in der Qualität individueller Batteriezellen nicht vollständig berücksichtigen.

Aufgabe der vorliegenden Erfindung ist es, ein Verfahren, ein entsprechendes Computerprogrammprodukt, ein entsprechendes computerlesbares Speichermedium sowie eine entsprechende Formierungsvorrichtung zu schaffen, mittels welchen verbessert ein Formierungsprozess überwacht beziehungsweise gesteuert werden kann.

Diese Aufgabe wird durch ein Verfahren, ein Computerprogrammprodukt, ein computerlesbares Speichermedium sowie eine Formierungsvorrichtung gemäß den unabhängigen Patentansprüchen gelöst. Vorteilhafte Ausgestaltungsformen sind in den Unteransprüchen angegeben.

Ein Aspekt der Erfindung betrifft ein Verfahren zum Überwachen eines Formierungsprozesses einer Batteriezelle mittels einer Formierungsvorrichtung. Es wird die Batteriezelle mit zumindest einem ersten Formierungsstrom mittels einer Ladeeinrichtung der Formierungsvorrichtung geladen. Es erfolgt das Durchführen zumindest einer Impedanzmessung während des Formierungsprozesses mittels einer Erfassungseinrichtung der Formierungsvorrichtung. Es wird ein Ersatzschaltbild der Batteriezelle im Formierungsprozess mittels einer elektronischen Recheneinrichtung der Formierungsvorrichtung vorgegeben. Es erfolgt ein Bestimmen von zumindest einem Parameter des Ersatzschaltbildes in Abhängigkeit von der durchgeführten Impedanzmessung mittels der elektronischen Recheneinrichtung und das Überwachen des Formierungsprozesses in Abhängigkeit von dem bestimmten zumindest einen Parameter mittels der elektronischen Recheneinrichtung.

Somit kann verbessert der Formierungsprozess entsprechend überwacht werden und beispielsweise auf Basis der Überwachung eine entsprechende Steuerung des Formierungsprozesses realisiert werden.

Insbesondere nutzt somit die Erfindung die Messung der elektrochemischen Impedanz während des Formierungsprozesses, um den aktuellen Zustand der Solid Electrolyte Interface (SEI - Festelektrolyt-Interphase) zu bestimmen und somit den Prozess möglichst effizient zu regeln, um gleichzeitig eine ausreichende Qualität der SEI zu gewährleisteten.

Zur Bestimmung der Impedanz eignet sich die elektrochemische Impedanz-Spektroskopie (EIS). Bestimmte Frequenzbereiche oder einzelne Werte aus einem Impedanzspektrum können dann genutzt werden, um den Beitrag der SEI zur Gesamt-Impedanz zu identifizieren. Hierzu wird insbesondere ein entsprechendes Ersatzschaltbild der Batteriezelle während des Formierungsprozesses gewählt. Dabei ist insbesondere vorgesehen, dass die Parameter des Ersatzschaltbildes an die entsprechenden Messwerte im Impedanzspektrum gefittet werden, um diese Parameter für die individuelle Batteriezelle zu bestimmen. Dabei wird insbesondere ein Teil des Ersatzschaltbildes zur Beschreibung der SEI herangezogen. Die Werte beziehungsweise Parameter ändern sich während der Formierung, da durch eine zunehmende Dicke der SEI beispielsweise deren Widerstand zunimmt. Auch kann beispielsweise die Kapazität sowohl durch die Dicke der SEI als auch durch deren effektive Oberfläche beeinflusst werden. Die Bestimmung dieser Parameter oder auch vergleichbarer Parameter aus alternativen Ersatzschaltbildern ergibt also eine Beschreibung der SEI zum Zeitpunkt der Impedanzmessung.

Insbesondere kann somit im Vergleich zum Vorgehen gemäß dem Stand der Technik während des Formierungsprozesses eine jede Batteriezelle einem im Wesentlichen optimierten Formierungsprozess zugeführt werden. Dabei wird der Formierungsprozess beschleunigt, wenn beispielsweise die elektrischen Parameter, die der SEI zugeordnet werden, die Möglichkeit einer schnelleren Bildung der gewünschten SEI andeutet, und verlangsamt, wenn der Formierungsprozess die Bildung der gewünschten SEI gefährden würde. Dabei lässt sich der deatillierte Einfluss der Regelgröße auf die Steuerungsgrößen, insbesondere Strom oder Spannung, individuell für jeden Batteriezellentyp einstellen.

Gemäß einer vorteilhaften Ausgestaltungsform wird als Parameter ein Ohm'scher Widerstand und/oder eine Kapazität des Ersatzschaltbildes bestimmt. Insbesondere kann beispielsweise der Widerstand und/oder die Kapazität der Fest-Elektrolyt-Interphase zugeordnet werden. Auf Basis des bestimmten Ersatzschaltbildes kann nun ein entsprechendes Parameterfitting durchgeführt werden, welches den Werten der Impedanzmessung entspricht. Somit kann ein einfaches Ersatzschaltbild bereitgestellt werden, welches durch einfache Fitting-Algorithmen entsprechend ausgewertet werden kann, wodurch zuverlässig die Überwachung des Formierungsprozesses durchgeführt werden kann.

Dabei sieht eine vorteilhafte Ausgestaltungsform vor, dass der Ohm'sche Widerstand und die Kapazität als Parallelschaltung im Ersatzschaltbild vorgegeben werden. Mit anderen Worten wird das Ersatzschaltbild derart bereitgestellt, dass der Ohm'sche Widerstand und die Kapazität parallel zueinander verlaufen. Somit kann ein einfaches Ersatzschaltbild für die SEI-Formierung bereitgestellt werden, welches dennoch eine zuverlässige Überwachung des Formierungsprozesses erlaubt.

Weiterhin vorteilhaft ist, wenn der zumindest eine Parameter einer Fest-Elektrolyt-Interphase einer Elektrode der Batteriezelle zugeordnet wird. Insbesondere kann somit die Bildung der Fest-Elektrolyt-Interphase (SEI) überwacht werden. Insbesondere die Überwachung der Fest-Elektrolyt-Interphase ist von entscheidender Bedeutung, um die Qualität der Batteriezelle entsprechend zu beeinflussen.

In einer weiteren vorteilhaften Ausgestaltungsform kann vorgesehen sein, dass auf Basis des bestimmten Parameters ein zweiter Formierungsstrom für den Formierungsprozess bestimmt wird. Insbesondere können auch mehrere Formierungsströme entsprechend bestimmt werden. Insbesondere ist somit vorgesehen, dass eine Regelung des Formierungsprozesses auf Basis des bestimmten Parameters durchgeführt wird. Insbesondere sollte beispielsweise der bestimmte Parameter nicht dem gewünschten Parameter entsprechen, so kann ein anderer Formierungsstrom oder auch eine andere Formierungsspannung gewählt werden, so dass sich der bestimmte Parameter bei der nächsten Impedanzmessung an den vorgegebenen Parameter angleicht. Somit kann eine Regelung des Formierungsprozesses vorteilhaft durchgeführt werden.

In einer weiteren vorteilhaften Ausgestaltungsform ist vorgesehen, dass die Impedanzmessung mit einer Soll-Impedanzmessung einer Referenzbatteriezelle verglichen wird. Die Referenzbatteriezelle kann auch als so genannter "Golden-Sample" bezeichnet werden. Bei dieser handelt es sich insbesondere um eine Batteriezelle, welche den entsprechenden Vorgaben beziehungsweise der Qualität und beispielsweise auch einer vorgegebenen SEI entspricht. Die Impedanzmessung kann nun mit der Soll-Impedanzmessung verglichen werden und es kann dann in Abhängigkeit von dem Vergleich entschieden werden, ob beispielsweise eine Anpassung des Formierungsstroms oder auch eine Anpassung der Formierungsspannung entsprechend durchzuführen ist, um sich im Wesentlichen der Impedanzmessung der Soll-Impedanzmessung anzugleichen. Somit kann eine vorteilhafte Regelung des Formierungsprozesses realisiert werden.

Ebenfalls vorteilhaft ist, wenn ein Vergleich bei einem gleichen Ladezustand der Batteriezelle und der Referenzbatteriezelle durchgeführt wird. Mit anderen Worten ist insbesondere der Vergleich nicht zeitlich abhängig, sondern ladezustandsabhängig. Wenn also die Batteriezelle im Wesentlichen den gleichen Ladezustand aufweist wie die Referenzbatteriezelle, dann werden die entsprechenden Impedanzmessungen miteinander verglichen. Dadurch kann ein verbesserter Vergleich der Batteriezellen miteinander durchgeführt werden.

In einer weiteren vorteilhaften Ausgestaltungsform ist vorgesehen, dass ein Vergleich bei einem gleichen Formierungsschritt im Formierungsprozess der Batteriezelle und der Referenzbatteriezelle durchgeführt wird. Beispielsweise kann der Formierungsprozess mehrere Formierungsschritte aufweisen, welche bei einem gleichen Strom (Constant Current - CC) sowie einer gleichen Spannung (Constant Voltage - CV) durchgeführt werden. Es ist dann vorgesehen, dass der Vergleich der beiden Batteriezellen dann durchgeführt wird, wenn beide beispielsweise in einem Constant-Current-Schritt beziehungsweise beide in einem Constant-Voltage-Schritt sind beziehungsweise waren. Somit kann ein verbesserter Vergleich der beiden Batteriezellen durchgeführt werden.

Gemäß einer weiteren vorteilhaften Ausgestaltungsform ist vorgesehen, dass eine potentiostatische und/oder galvanostatische Impedanzmessung durchgeführt wird. Somit können unterschiedliche Impedanzmessungen bereitgestellt werden, welche es ermöglichen, zuverlässig das entsprechende Ersatzschaltbild zu bestimmen und die Parameter zu bestimmen. Somit kann zuverlässig die Überwachung der Batteriezelle durchgeführt werden.

Eine weitere vorteilhafte Ausgestaltungsform sieht vor, dass in vorgegebenen Zeitabschnitte des Formierungsprozesses eine jeweilige Impedanzmessung durchgeführt wird. Beispielsweise kann minütlich, stündlich, täglich oder dergleichen die Impedanzmessung durchgeführt werden. Die Zeitabschnitte können dabei auch unterschiedlich sein, und beispielsweise den entsprechenden Formierungsschritten zugeordnet werden. Mit anderen Worten ist vorgesehen, dass mehrere Impedanzmessungen während des Formierungsprozesses durchgeführt werden.

Somit kann der Formierungsprozess stetig adaptiert werden, wodurch ein verbesserter Formierungsprozess realisiert werden kann.

In einer weiteren vorteilhaften Ausgestaltungsform ist vorgesehen, dass zum Durchführen der Impedanzmessung der Formierungsstrom unterbrochen wird. Mit anderen Worten wird der Formierungsstrom der Ladeeinrichtung kurzzeitig unterbrochen und die Impedanzmessung durchgeführt. Somit kann auf einfache Art und Weise die Impedanzmessung durchgeführt werden und ein entsprechendes Parameterfitting realisiert werden.

Alternativ oder ergänzend hierzu kann vorgesehen sein, dass zum Durchführen der Impedanzmessung der Formierungsstrom überlagert wird. Mit anderen Worten wird der Formierungsstrom mit den entsprechenden Signalen der Impedanzmessung überlagert. Somit muss der Formierungsprozess nicht unterbrochen werden und insbesondere kann somit der Formierungsprozess schneller durchgeführt werden.

Bei dem vorgestellten Verfahren handelt es sich insbesondere um ein computerimplementiertes Verfahren. Daher betrifft ein weiterer Aspekt der Erfindung ein Computerprogrammprodukt mit Programmcodemitteln, welche eine elektronische Recheneinrichtung dazu veranlassen, wenn die Programmcodemittel von der elektronischen Recheneinrichtung abgearbeitet werden, ein Verfahren nach dem vorhergehenden Aspekt durchzuführen.

Ein nochmals weiterer Aspekt der Erfindung betrifft ein computerlesbares Speichermedium mit zumindest dem Computerprogrammprodukt nach dem vorhergehenden Aspekt.

Ferner betrifft die Erfindung auch eine Formierungsvorrichtung zur Überwachung eines Formierungsprozesses einer Batteriezelle, mit zumindest einer Ladeeinrichtung, einer Erfassungseinrichtung und einer elektronischen Recheneinrichtung, wobei die Formierungsvorrichtung zum Durchführen eines Verfahrens nach dem vorhergehenden Aspekt ausgebildet ist. Insbesondere wird das Verfahren mittels der Formierungsvorrichtung durchgeführt.

Weiterhin ist die Formierungsvorrichtung auch zum Durchführen des Formierungsprozesses ausgebildet.

Vorteilhafte Ausgestaltungsformen des Verfahrens sind als vorteilhafte Ausgestaltungsformen des Computerprogrammprodukts, des computerlesbaren Speichermediums sowie der Formierungsvorrichtung anzusehen. Die Formierungsvorrichtung weist hierzu gegenständliche Merkmale auf, um entsprechende Verfahrensschritte durchführen zu können.

Unter einer Recheneinheit/elektronische Recheneinrichtung kann insbesondere ein Datenverarbeitungsgerät verstanden werden, das einen Verarbeitungsschaltkreis enthält. Die Recheneinheit kann also insbesondere Daten zur Durchführung von Rechenoperationen verarbeiten. Darunter fallen gegebenenfalls auch Operationen, um indizierte Zugriffe auf eine Datenstruktur, beispielsweise eine Umsetzungstabelle, LUT (englisch: "look-up table"), durchzuführen.

Die Recheneinheit kann insbesondere einen oder mehrere Computer, einen oder mehrere Mikrocontroller und/oder einen oder mehrere integrierte Schaltkreise enthalten, beispielsweise eine oder mehrere anwendungsspezifische integrierte Schaltungen, ASIC (englisch: "application-specific integrated circuit"), eines oder mehrere feldprogrammierbare Gate-Arrays, FPGA, und/oder eines oder mehrere Einchipsysteme, SoC (englisch: "system on a chip"). Die Recheneinheit kann auch einen oder mehrere Prozessoren, beispielsweise einen oder mehrere Mikroprozessoren, eine oder mehrere zentrale Prozessoreinheiten, CPU (englisch: "central processing unit"), eine oder mehrere Grafikprozessoreinheiten, GPU (englisch: "graphics processing unit") und/oder einen oder mehrere Signalprozessoren, insbesondere einen oder mehrere Digitalsignalprozessoren, DSP, enthalten. Die Recheneinheit kann auch einen physischen oder einen virtuellen Verbund von Computern oder sonstigen der genannten Einheiten beinhalten.

In verschiedenen Ausführungsbeispielen beinhaltet die Recheneinheit eine oder mehrere Hardware- und/oder Softwareschnittstellen und/oder eine oder mehrere Speichereinheiten.

Eine Speichereinheit kann als flüchtiger Datenspeicher, beispielsweise als dynamischer Speicher mit wahlfreiem Zugriff, DRAM (englisch: "dynamic random access memory") oder statischer Speicher mit wahlfreiem Zugriff, SRAM (englisch: "static random access memory"), oder als nicht-flüchtiger Datenspeicher, beispielsweise als Festwertspeicher, ROM (englisch: "read-only memory"), als programmierbarer Festwertspeicher, PROM (englisch: "programmable read-only memory"), als löschbarer programmierbarer Festwertspeicher, EPROM (englisch: "erasable programmable read-only memory"), als elektrisch löschbarer programmierbarer Festwertspeicher, EEPROM (englisch: "electrically erasable programmable read-only memory"), als Flash-Speicher oder Flash-EEPROM, als ferroelektrischer Speicher mit wahlfreiem Zugriff, FRAM (englisch: "ferroelectric random access memory"), als magnetoresistiver Speicher mit wahlfreiem Zugriff, MRAM (englisch: "magnetoresistive random access memory") oder als Phasenänderungsspeicher mit wahlfreiem Zugriff, PCRAM (englisch: "phase-change random access memory"), ausgestaltet sein.

Hier und im Folgenden kann ein künstliches neuronales Netzwerk als Softwarecode verstanden werden, der auf einem computerlesbaren Speichermedium gespeichert ist und eines oder mehrere vernetzte künstliche Neuronen repräsentiert beziehungsweise deren Funktion nachbilden kann. Der Softwarecode kann dabei auch mehrere Softwarecodekomponenten beinhalten, die beispielsweise unterschiedliche Funktionen haben können. Insbesondere kann ein künstliches neuronales Netzwerk ein nichtlineares Modell oder einen nichtlinearen Algorithmus implementieren, das beziehungsweise der eine Eingabe auf eine Ausgabe abbildet, wobei die Eingabe durch einen Eingangsmerkmalsvektor oder eine Eingangssequenz gegeben ist und die Ausgabe beispielsweise eine ausgegebenen Kategorie für eine Klassifizierungsaufgabe, einen oder mehrere prädizierte Werte oder eine prädizierte Sequenz beinhalten kann.

Für Anwendungsfälle oder Anwendungssituationen, die sich bei einem erfindungsgemäßen Verfahren ergeben können und die hierin nicht explizit beschrieben sind, kann vorgesehen sein, dass gemäß dem Verfahren eine Fehlermeldung und/oder eine Aufforderung zur Eingabe einer Nutzerrückmeldung ausgegeben und/oder eine Standardeinstellung und/oder ein vorbestimmter Initialzustand eingestellt wird.

Unabhängig vom grammatikalischen Geschlecht eines bestimmten Begriffes sind Personen mit männlicher, weiblicher oder anderer Geschlechteridentität mit umfasst.

Weitere Merkmale und Merkmalskombinationen der Erfindung ergeben sich aus den Figuren und deren Beschreibungen sowie aus den Ansprüchen. Insbesondere müssen weitere Ausführungsformen der Erfindung nicht unbedingt alle Merkmale eines der Ansprüche enthalten. Weitere Ausführungsformen der Erfindungen können Merkmale oder Merkmalskombinationen aufweisen, die nicht in den Ansprüchen genannt sind.

Dabei zeigen:
- Fig. 1: ein schematisches Blockschaltbild gemäß einer Ausführungsform einer Formierungsvorrichtung;
- Fig. 2: ein schematisches Ersatzschaltbild einer Ausführungsform einer Batteriezelle;
- Fig. 3: schematische Zeitdiagramme gemäß eines Formierungsprozesses; und
- Fig. 4: ein schematisches Spannung-Widerstands-Diagramm für einen Formierungsprozess.

In den Figuren sind gleiche oder funktionsgleiche Elemente mit den gleichen Bezugszeichen versehen.

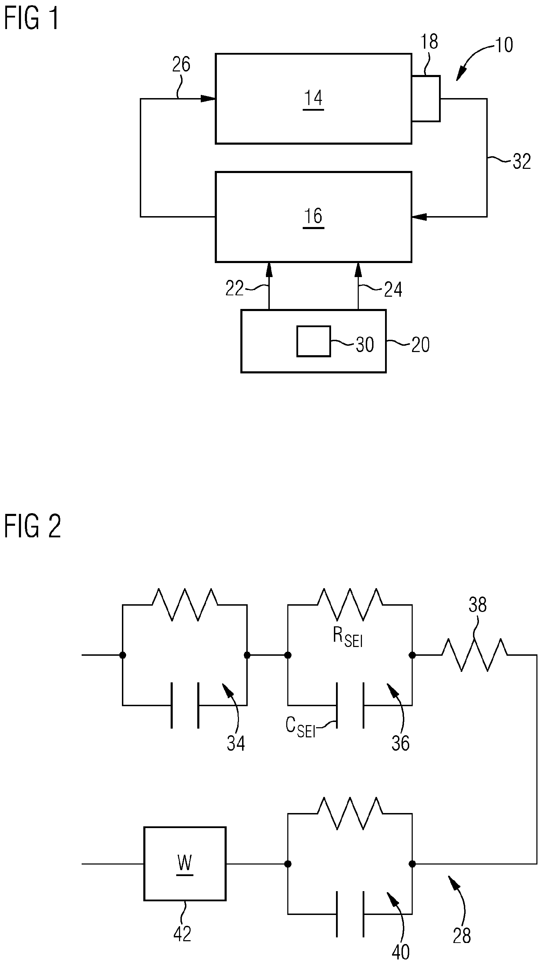

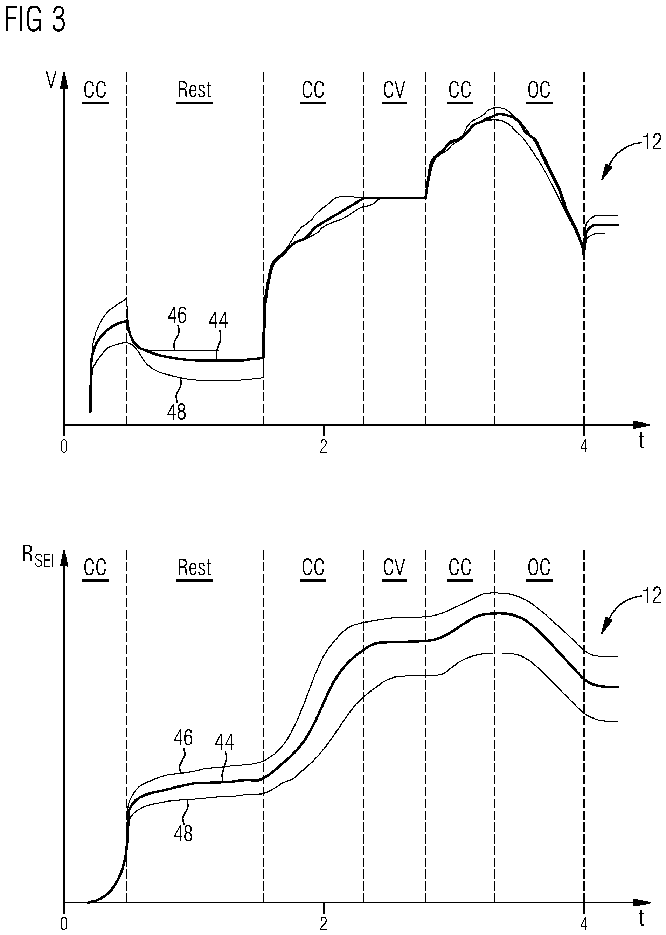

Fig. 1 zeigt ein schematisches Blockschaltbild gemäß einer Ausführungsform einer Formierungsvorrichtung 10. Die Formierungsvorrichtung 10 ist zum Überwachen eines Formierungsprozesses 12 (Fig. 3) einer Batteriezelle 14 ausgebildet. Die Formierungsvorrichtung 10 weist hierzu zumindest eine Ladeeinrichtung 16, eine Erfassungseinrichtung 18 sowie eine elektronische Recheneinrichtung 20 auf. Über die elektronische Recheneinrichtung 20 kann insbesondere eine Regelung der Ladeeinrichtung 16 durchgeführt werden. Insbesondere können hierzu beispielsweise Referenzwerte 22 bezüglich Spannung und Strom vorgegeben werden, insbesondere bezüglich des Formierungsprozesses 12. Des Weiteren kann eine Soll-Wertkurve 24 vorgegeben werden, welche beispielsweise einen Ohm'schen Widerstand R_{SEI} in Abhängigkeit von der Spannung vorgibt. Das Laden der Batteriezelle 14 kann dann über den Strom I oder die vorgegebene Spannung V erfolgen. Mittels der Erfassungseinrichtung 18 kann dann beispielsweise der Ohm'sche Widerstand R_{SEI} in Abhängigkeit von der Spannung der Batteriezelle 14 erfasst werden.

Insbesondere kann somit vorgesehen sein, dass mittels der Formierungsvorrichtung 10 die Batteriezelle 14 mit einem ersten Formierungsstrom 26 geladen wird. Es wird eine Impedanzmessung 32 während des Formierungsprozesses 12 mittels der Erfassungseinrichtung 18 durchgeführt. Es wird ein Ersatzschaltbild 28 (Fig. 2) der Batteriezelle 14 im Formierungsprozess 12 mittels der elektronischen Recheneinrichtung 20 vorgegeben. Es wird zumindest ein Parameter 30 des Ersatzschaltbildes 28 in Abhängigkeit von der durchgeführten Impedanzmessung 32 mittels der elektronischen Recheneinrichtung 20 bestimmt und es erfolgt das Überwachen des Formierungsprozesses 12 in Abhängigkeit von dem bestimmten zumindest einen Parameter 30 mittels der elektronischen Recheneinrichtung 20. Ferner kann insbesondere vorgesehen sein, dass zumindest eine potentiostatische und/oder eine galvanostatische Impedanzmessung 32 durchgeführt werden.

Fig. 2 zeigt ein schematisches Ersatzschaltbild 28 einer Ausführungsform einer Batteriezelle 14. Dabei zeigt die Fig. 2 insbesondere, dass die Batteriezelle 14 mit unterschiedlichen elektrischen Bauteilen beschrieben werden kann. Beispielsweise kann eine erste Parallelschaltung 34 im Wesentlichen eine Anode der Batteriezelle 14 beschreiben. Eine zweite Parallelschaltung 36 kann wiederum eine Fest-Elektrolyt-Interphase (SEI) einer Elektrode, insbesondere der Anode 34, beschreiben. Ein erster Ohm'scher Widerstand 38 beschreibt wiederum beispielsweise einen Leitungswiderstand der Batteriezelle 14 und eine dritte Parallelschaltung 40 kann beispielsweise die Kathode beschreiben. Ferner ist weiter noch ein Warburg-Element 42 gezeigt. Das Ersatzschaltbild 28 ist hier rein beispielhaft. Es ist selbstverständlich, dass auch weitere Ersatzschaltbilder 28 verwendet werden können.

Im vorliegenden Ausführungsbeispiel ist insbesondere die zweite Parallelschaltung 36 von Relevanz, welche insbesondere den Ohm'schen Widerstand R_{SEI} darstellt, sowie eine Kapazität C_{SEI}. Mit anderen Worten ist vorgesehen, dass der Parameter 30, insbesondere der Ohm'sche Widerstand R_{SEI} und/oder die Kapazität C_{SEI} des Ersatzschaltbildes 28 bestimmt wird. Dabei ist der Ohm'sche Widerstand R_{SEI} und die Kapazität C_{SEI} als Parallelschaltung, insbesondere vorliegend als zweite Parallelschaltung 36, im Ersatzschaltbild 28 vorgegeben. Der zumindest eine Parameter 30 wird dabei insbesondere der Fest-Elektrolyt-Interphase einer Elektrode der Batteriezelle 14 zugeordnet.

Fig. 3 zeigt wiederum zwei Zeitdiagramme. Im oberen Diagramm ist auf der Abszisse die Zeit t dargestellt und auf der Ordinate eine Spannung V. Im unteren Diagramm ist auf der Abszisse die Zeit t aufgetragen und auf der Ordinate der Ohm'sche Widerstand R_{SEI}. Insbesondere zeigen die Figuren beziehungsweise die Diagramme unterschiedliche Formierungsschritte während des Formierungsprozesses 12. Beispielsweise ist ein Constant-Current-Formierungsschritt (CC), ein Pausenschritt (Rest), ein Current-Voltage (CV) sowie ein Open-Circuit-Schritt (OC) gezeigt. Dabei zeigt die Fig. 3 insbesondere eine erste Linie 44, welche insbesondere einer Linie einer Referenzbatteriezelle entspricht. Des Weiteren sind eine zweite Linie 46 sowie eine dritte Linie 48 gezeigt, welchen beispielsweise anderen Batteriezellen entsprechen.

Insbesondere zeigt die Fig. 3, dass beispielsweise die Impedanzmessung 32 mit einer Soll-Impedanzmessung einer Referenzbatteriezelle verglichen wird. Dabei kann ein Vergleich bei einem gleichen Ladezustand der Batteriezelle 14, wie bei der Referenzbatteriezelle, durchgeführt werden, sowie alternativ oder ergänzend bei einem gleichen Formierungsschritt, beispielsweise den Constant-Current (CC), der Pausenzeit (Rest), der Current-Voltage (CV) sowie Open-Circuit (OC) durchgeführt werden. Des Weiteren zeigt die Fig. 3 insbesondere, dass in vorgegebenen Zeitabständen des Formierungsprozesses 12 eine jeweilige Impedanzmessung 32 durchgeführt werden kann.

Insbesondere ist somit vorgesehen, dass die elektrochemische Impedanz während des Formierungsprozesses 12 um den aktuellen Zustand der SEI zu bestimmen und somit der Prozess möglichst effizient geregelt werden kann, bestimmt wird, und gleichzeitig eine ausreichende Qualität der SEI zu gewährleisten.

Zur Bestimmung der Impedanz eignet sich die elektrochemische Impedanzspektroskopie (EIS). Bestimmte Frequenzbereiche oder einzelne Werte aus einen Impedanzspektrum können dann genutzt werden, um den Beitrag der SEI zur Gesamt-Impedanz zu identifizieren. Wie bereits bekannt, werden die Parameter 30 des Ersatzschaltbilds 28 an die Messwerte des Impedanzspektrums gefittet, um diese Parameter 30 für die individuelle Batteriezelle 14 zu bestimmen. Dabei wird insbesondere ein Teil des Ersatzschaltbildes 28 zur Beschreibung der SEI herangezogen, insbesondere die zweite Parallelschaltung 36. Im Beispiel wird diese durch einen effektiven Ohm'schen Widerstand R_{SEI} und eine effektive Kapazität C_{SEI} parametrisiert. Diese Werte ändern sich während der Formierung, da durch eine zunehmende Dicke der SEI deren Widerstand zunimmt. Auch die Kapazität wird sowohl durch die Dicke der SEI als auch durch die effektive Oberfläche beeinflusst. Die Bestimmung dieser Parameter 30 oder vergleichbarer Parameter aus alternativen Ersatzschaltbildern ergibt also eine Beschreibung der SEI zum Zeitpunkt der Impedanzmessung 32.

Konkret wird zunächst ein idealer Formierungsprozess entwickelt, welcher zur gewünschten Performance einer idealen Referenzbatteriezelle, welche auch als Golden Sample bezeichnet werden kann, führt. Für diesen Prozess werden standardmäßig die Stromverläufe I (t) und Spannungsverläufe V (t) aufgezeichnet. Während des Prozesses wird nun zu mehreren Zeitpunkten eine potentiostatische und/oder galvanostatische EIS durchgeführt. Entweder wird der Prozess dazu kurz, beispielsweise höchstens wenige Sekunden, unterbrochen, oder die Spannungs-/Stromanregung der EIS-Methode werden im eigentlichen Prozess überlagert. Wie zuvor beschrieben, werden aus den Impedanzspektren die relevanten SEI-Parameter zum aktuellen Zeitpunkt bestimmt (zum Beispiel R_{SEI} (t), C_{SEI} (t)). Diese stellen zusammen mit den Strom-/Spannungsverläufen das Vorbild für eine optimale SEI-Formierung dar. Für jede individuelle Batteriezelle 14 wird nun ebenfalls die Impedanz an ausgewählten Zeitpunkten während der Formierung gemessen, wobei mit dem gleichen Prozess wie beim Golden Sample gestartet werden kann. Falls die gleiche Prozessführung, also die gleiche Vorgabe von Strom- oder Spannungsverläufen, für die Batteriezelle 14 gewählt wird, so kann dies zu unterschiedlichen Messwerten führen. Beispielsweise haben die individuellen Batteriezellen 14 eine geringere Gesamt-Impedanz, was durch die zweite Linie 46 dargestellt ist, oder eine höhere Gesamt-Impedanz, was durch die dritte Linie 48 dargestellt ist, so dass im ersten Schritt bei der Ladung mit einem vorgegebenen konstanten Strom (CC) eine geringere/höhere Überspannung im Vergleich zum Golden Sample auftritt. Das kann beispielsweise dazu führen, dass mehr/weniger Strom zur Aufladung der Batteriezelle 14 verwendet wird und weniger/mehr Strom in die SEI-Formierung fließt, was eine höhere/niedrigere Spannung am Ende der folgenden Ruhestufe (Rest) zur Folge hat. Da weniger/mehr SEI gebildet wurde, ist der Ohm'sehe Widerstand R_{SEI} (t) am Ende der Ruhestufe entsprechend geringer/höher als beim Golden Sample. Während der folgenden Schritte bei konstantem Strom (CC) beziehungsweise bei konstanter Spannung (CV) führt dies dazu, dass sich die SEI nicht in gleichem Maß weiterbildet wie beim Golden Sample und die Batteriezelle 14 sich bezüglich der Beschaffenheit ihrer SEI am Ende des Formierungsprozesses 12 voneinander unterscheiden.

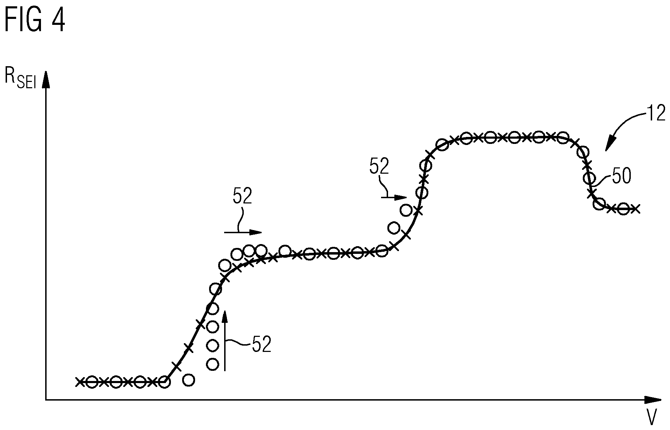

Fig. 4 zeigt ein Spannungs-Ohm'scher Widerstand-Schaltbild. Dabei sind durch die Kreuze insbesondere die Messwerte der Golden Sample gezeigt, ein Kurvenverlauf 50 beschreibt dabei insbesondere eine Soll-Wertkurve sowie durch Kreise die entsprechenden Messwerte der individuellen Batteriezelle 14 gezeigt. Des Weiteren stellen Pfeile 52 eine entsprechende Prozessregelung dar.

Insbesondere zeigt somit die Fig. 4, dass die Regelung der Prozessführung vorgeschlagen werden kann, die sich an den Fit-Parametern des Ersatzschaltbildes 28, welche die SEI beschreiben, orientiert. Um diese Parameter 30 zwischen individuellen Zellen und Golden Sample vergleichen zu können, ist es wichtig, dass alle Batteriezellen im jeweils gleichen Zustand betrachtet werden. Betrachtet man einen Prozessabschnitt mit CC, so eignet sich die Spannung, um den Zustand der Batteriezelle 14 im Prozess zu identifizieren. Im Beispiel werden also die SEI-Parameter der Zellspannung V zugeordnet, bei welcher die Impedanzmessung 32 stattfindet. Ein Vergleich dieser Werte von individuellen Batteriezellen 14 mit den entsprechenden Werten aus der Golden Sample-Messung erlaubt es nun, die vorgegebene Stromstärke zu regeln beziehungsweise zu justieren. Die Fig. 4 zeigt hierbei die Regelung des Stroms abhängig von dem Ohm'schen Widerstand R_{SEI} (V) schematisch.

Die Ladeeinrichtung 16 kann dabei insbesondere dem gemessenen Ohm'schen Widerstand R_{SEI} der aktuellen Spannung zuordnen und vergleicht diesen Wert mit dem Ohm'schen Widerstand der Referenzbatteriezelle, der für diesen Parameter 30 bei der Golden Sample-Messung bei gleicher Spannung aufgezeichnet wurde. Die Stellgröße, welche beim Stand der Technik fest vorgegeben ist, kann nun durch die Regelung nachjustiert werden, um den Unterschied zwischen den beiden Ohm'schen Widerständen zu verringern. Dabei stellen die Kreuze, wie bereits erwähnt, die Messwerte beziehungsweise Interpolation des Spannungs- und SEI-Verhaltens des Golden Samples dar. Die Kreise stellen die entsprechenden Messwerte von Spannung und R_{SEI} während der Formierung einer individuellen Batteriezelle 14 dar. Falls diese von der entsprechenden Referenzkurve 15 abweichen, werden die angelegten Strom- oder Spannungswerte so geregelt, dass die Abweichungen verringert werden. Die Stromstärke kann beispielsweise erhöht werden, wenn R_{SEI} langsamer als erwartet anwächst, was insbesondere durch einen Pfeil nach oben dargestellt ist, hier unter der Annahme, dass höhere Stromstärken beziehungsweise höhere Überspannungen ein schnelleres SEI-Wachstum bewirken, oder verringert werden, sofern die R_{SEI} bereits über dem Soll-Wert liegt, was durch einen Pfeil nach rechts dargestellt ist.

Wie bereits beschrieben erweitert die Regelung dieser Erfindung die bisherige Regelung basierend auf einem vorgegebenen Stromwert (CC). Nun wird die Differenz von R_{SEI} und dem entsprechenden Soll-Wert minimiert, es wird der Referenzwert der Stromstärke I aus dem Golden Sample-Prozess im Wesentlichen eingehalten. Der Einfluss beider Zielvorgaben auf die Regelung kann dabei gewichtet werden. Eine niedrige Gewichtung der Referenzwerte wird dabei geringere Abweichungen von der Soll-Wertkurve ermöglichen, allerdings zu deutlichen Abweichungen beim Golden Sample-Prozess führen. Falls der ursprüngliche Prozess vorsieht, bestimmte Spannungswerte V für eine definierte Dauer oder bis zu einer definierten Stromstärke zu erhalten (CV), so kann die Spannung entsprechend so lange gehalten werden, bis die jeweils zu erwartende SEI-Formierung, hier beschrieben durch die Referenzkurve 50, am Ende dieser Haltestufen erreicht wurde. Während vorgesehener Ruhephasen (Rest) kann wie bisher eine bestimmte Zeit abgewartet werden oder es wird ebenfalls bis zum Erreichen des Golden Sample gemessenen Widerstandswert gewartet.

Das Vorgehen lässt sich auf beliebige andere Prozessparameter ebenfalls erweitern, die neben der Spannung während des Formierungsprozesses durchlaufen werden, beispielsweise die Temperatur (R_{SEI} (V, t)). Es können ferner auch weitere Methoden aus dem Stand der Technik und andere Entwicklungen kombiniert werden. Beispielsweise können anstatt Impedanzmessungen 32 auch elektrische Pulse angelegt werden und deren zeitliches An-/Abklingverhalten genau untersucht werden, um relevante Impedanzwerte daraus zu ermitteln.

### Bezugszeichenliste

- 10: Formierungsvorrichtung
- 12: Formierungsprozess
- 14: Batteriezelle
- 16: Ladeeinrichtung
- 18: Erfassungseinrichtung
- 20: elektronische Recheneinrichtung
- 22: Referenzwerte
- 24: Soll-Wertkurve
- 26: Ladestrom
- 28: Ersatzschaltbild
- 30: Parameter
- 32: Impedanzmessung
- 34: erste Parallelschaltung
- 36: zweite Parallelschaltung
- 38: erster Ohm'scher Widerstand
- 40: dritte Parallelschaltung
- 42: Warburg-Element
- 44: erste Kurve
- 46: zweite Kurve
- 48: dritte Kurve
- 50: Referenzkurve
- 52: Prozessregelung
- C_{SEI}: Kapazität
- R_{SEI}: Ohm'scher Widerstand
- CC: Constant Current
- Rest: Pause
- CV: Constant Voltage
- OC: Open Circuit
- t: Zeit
- V: Spannung

## Patentansprüche

1. Verfahren zum Überwachen eines Formierungsprozesses (12) einer Batteriezelle (14) mittels einer Formierungsvorrichtung (10), mit den Schritten:
- Laden der Batteriezelle (14) mit zumindest einem ersten Formierungsstrom (26) mittels einer Ladeeinrichtung (16) der Formierungsvorrichtung (10);
- Durchführen zumindest einer Impedanzmessung (32) während des Formierungsprozesses (12) mittels einer Erfassungseinrichtung (18) der Formierungsvorrichtung (10);
- Vorgeben eines Ersatzschaltbildes (28) der Batteriezelle (14) im Formierungsprozess (12) mittels einer elektronischen Recheneinrichtung (20) der Formierungsvorrichtung (10);
- Bestimmen von zumindest einem Parameter (30) des Ersatzschaltbildes (28) in Abhängigkeit von der durchgeführten Impedanzmessung (32) mittels der elektronischen Recheneinrichtung (20); und
- Überwachen des Formierungsprozesses (12) in Abhängigkeit von dem bestimmten zumindest einem Parameter (30) mittels der elektronischen Recheneinrichtung (20).

2. Verfahren nach Anspruch 1, **dadurch gekennzeichnet, dass**
als Parameter (30) eine ohmscher Widerstand (R_{SEI}) und/oder eine Kapazität (C_{SEI}) des Ersatzschalbildes (28) bestimmt wird.

3. Verfahren nach Anspruch 2, **dadurch gekennzeichnet, dass**
der ohmsche Widerstand (R_{SEI}) und die Kapazität (C_{SEI}) als Parallelschaltung im Ersatzschaltbild (28) vorgegeben werden.

4. Verfahren nach einem der vorhergehenden Ansprüche, **dadurch gekennzeichnet, dass** der zumindest eine Parameter (30) einer Festelektrolyt-Interphase einer Elektrode der Batteriezelle (14) zugeordnet wird.

5. Verfahren nach einem der vorhergehenden Ansprüche, **dadurch gekennzeichnet, dass** auf Basis des bestimmten Parameters (30) ein zweiter Formierungsstrom (26) für den Formierungsprozess (12) bestimmt wird.

6. Verfahren nach einem der vorhergehenden Ansprüche, **dadurch gekennzeichnet, dass** die Impedanzmessung (32) mit einer Soll-Impedanzmessung einer Referenzbatteriezelle verglichen wird.

7. Verfahren nach Anspruch 6, **dadurch gekennzeichnet, dass**
ein Vergleich bei einem gleichen Ladezustand der Batteriezelle (14) und der Referenzbatteriezelle durchgeführt wird.

8. Verfahren nach Anspruch 6 oder 7, **dadurch gekennzeichnet, dass** ein Vergleich bei einem gleichen Formierungsschritt im Formierungsprozess (12) der Batteriezelle (14) und der Referenzbatteriezelle durchgeführt wird.

9. Verfahren nach einem der vorhergehenden Ansprüche, **dadurch gekennzeichnet, dass** eine potentiostatische und/oder eine galvanostatische Impedanzmessung (32) durchgeführt wird.

10. Verfahren nach einem der vorhergehenden Ansprüche, **dadurch gekennzeichnet, dass** in vorgegebene Zeitabschnitten des Formierungsprozesses (12) eine jeweilige Impedanzmessung (32) durchgeführt wird.

11. Verfahren nach einem der vorhergehenden Ansprüche, **dadurch gekennzeichnet, dass** zum Durchführen der Impedanzmessung (32) der Formierungsstrom (26) unterbrochen wird.

12. Verfahren nach einem der vorhergehenden Ansprüche, **dadurch gekennzeichnet, dass** zum Durchführen der Impedanzmessung (32) der Formierungsstrom (26) überlagert wird.

13. Computerprogrammprodukt mit Programmcodemitteln, welche eine elektronische Recheneinrichtung (20) dazu veranlassen, wenn die Programmcodemittel von der elektronischen Recheneinrichtung (20) abgearbeitet werden, ein Verfahren nach einem der Ansprüche 1 bis 12 durchzuführen.

14. Computerlesbares Speichermedium mit zumindest dem Computerprogrammprodukt nach Anspruch 13.

15. Formierungsvorrichtung (10) zum Überwachen eines Formierungsprozesses (12) einer Batteriezelle (14), mit zumindest einer Ladeeinrichtung (16), einer Erfassungseinrichtung (18) und einer elektronischen Recheneinrichtung (20), wobei die Formierungsvorrichtung (10) zum Durchführen eines Verfahrens nach einem der Ansprüche 1 bis 12 ausgebildet ist.
